# EUROPEAN PATENT APPLICATION

(11) **EP 4 723 463 A1**
(43) Date of publication of application: **08.04.2026**
(21) Application number: 23939634.4
(22) Date of filing: 31.05.2023
(51) Int. Cl.: H02M 7/48

(54) **DC POWER TRANSMISSION CONVERTER AND DC POWER TRANSMISSION CONVERSION UNIT**

(71) Applicant: MITSUBISHI ELECTRIC CORPORATION, Chiyoda-ku Tokyo 100-8310 (JP)
(72) Inventor: ISHIGURO, Junya, Tokyo 100-8310 (JP); SADAKUNI, Hitoshi, Tokyo 100-8310 (JP)
(74) Representative: Witte, Weller & Partner Patentanwälte mbB
(86) International application number: PCT/JP2023/020261
(87) International publication number: WO 2024/247158

(57) **Abstract**

The DC power transmission converter (10) includes a power supply device (1), a mounting frame (2) on which the power supply device (1) is mounted, and a support member (3) that supports the mounting frame (2). The support member (3) includes a first support member (31) and a second support member (32). The first support member (31) is fixed to the mounting frame (2). The second support member (32) is detachably attached to the mounting frame (2).

## Description

### TECHNICAL FIELD

The present disclosure relates to a DC power transmission converter and a DC power transmission conversion unit.

### BACKGROUND ART

In a DC power transmission converter, a plurality of power supply devices called submodules are connected in series and mounted on a mounting frame. In order to electrically insulate the mounting frame from a platform, the mounting frame is supported by a support member which is an electrical insulator. The support member is required to satisfy the earthquake resistance requirement of the DC power transmission converter.

For example, Japanese Patent Laying-Open No. 7-211858 (PTL 1) describes a thyristor valve in which a plurality of thyristor modules are mounted on module support plates which are supported by insulation columns and arranged in multiple stages. In the thyristor valve described in PTL 1, an insulation reinforcement tube is inserted inside an end of each insulation column. As a result, the earthquake resistance of each insulation column is enhanced.

### CITATION LIST

### PATENT LITERATURE

PTL 1: Japanese Patent Laying-Open No. 7-211858

### SUMMARY OF INVENTION

### TECHNICAL PROBLEM

In the thyristor valve described in PTL 1, the insulation columns are fixed to the module support plates. Therefore, the insulation columns are applied permanently during the operation period as well. Thus, the insulation columns lead to a product design constraint and an increase in cost.

The present disclosure has been made to solve the aforementioned problem, and an object of the present disclosure is to provide a DC power transmission converter and a DC power transmission conversion unit that satisfy the earthquake resistance requirement and can be applied temporarily.

### SOLUTION TO PROBLEM

A DC power transmission converter according to the present disclosure includes a power supply device, a mounting frame on which the power supply device is mounted, and a support member that supports the mounting frame. The support member includes a first support member and a second support member. The first support member is fixed to the mounting frame. The second support member is detachably attached to the mounting frame.

### ADVANTAGEOUS EFFECTS OF INVENTION

The DC power transmission converter according to the present disclosure can satisfy the earthquake resistance requirement and can be applied temporarily.

### BRIEF DESCRIPTION OF DRAWINGS

Fig. 1 is a front view schematically illustrating a DC power transmission converter according to a first embodiment.
Fig. 2 is a side view schematically illustrating the DC power transmission converter according to the first embodiment.
Fig. 3 is an enlarged cross-sectional view taken along line III-III of Fig. 1.
Fig. 4 is an enlarged view of a portion IV in Fig. 1.
Fig. 5 is a front view schematically illustrating a DC power transmission converter according to a first comparative example.
Fig. 6 is a side view schematically illustrating the DC power transmission converter according to the first comparative example.
Fig. 7 is a front view schematically illustrating a DC power transmission converter according to a second comparative example.
Fig. 8 is a side view schematically illustrating the DC power transmission converter according to the second comparative example.
Fig. 9 is a front view schematically illustrating a DC power transmission converter according to a second embodiment.
Fig. 10 is a side view schematically illustrating the DC power transmission converter according to the second embodiment.
Fig. 11 is an enlarged cross-sectional view taken along line XI-XI of Fig. 9.
Fig. 12 is a front view schematically illustrating a DC power transmission conversion unit according to a third embodiment.
Fig. 13 is a front view schematically illustrating a modification of the DC power transmission conversion unit according to the third embodiment.

### DESCRIPTION OF EMBODIMENTS

Hereinafter, embodiments will be described with reference to the drawings. In the drawings, the same or corresponding parts will be denoted by the same reference numerals, and the description thereof will not be repeated.

### First Embodiment.

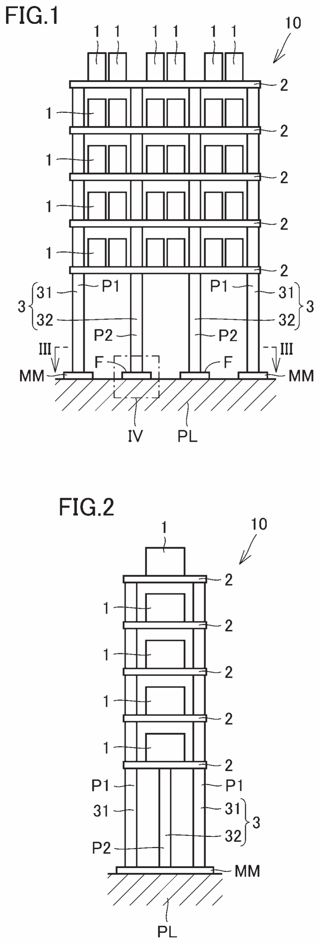

With reference to Figs. 1 and 2, the configuration of a DC power transmission converter 10 according to a first embodiment will be described. DC power transmission converter 10 according to the first embodiment is, for example, an offshore DC power transmission converter installed on ocean. DC power transmission converter 10 according to the first embodiment may be, for example, a land DC power transmission converter installed on land.

DC power transmission converter 10 according to the first embodiment is, for example, a high voltage direct current (HVDC) power transmission converter. DC power transmission converter 10 according to the first embodiment is not limited to a high voltage direct current power transmission converter.

DC power transmission converter 10 according to the first embodiment includes a power supply device 1, a mounting frame 2, and a support member 3.

Power supply device 1 is referred to as a sub-module. Power supply device 1 is installed on mounting frame 2. In the present embodiment, DC power transmission converter 10 includes a plurality of power supply devices 1. The plurality of power supply devices 1 are electrically connected in series.

Power supply device 1 is mounted on mounting frame 2. Mounting frame 2 is electrically insulated from a platform PL. Mounting frame 2 is an insulator. In the present embodiment, DC power transmission converter 10 includes a plurality of mounting frames 2. In the present embodiment, a plurality of power supply devices 1 are mounted on each of the plurality of mounting frames 2. In the present embodiment, the plurality of mounting frames 2 are stacked in multiple stages so as to overlap with each other in the vertical direction.

Support member 3 supports mounting frame 2. Support member 3 is configured to support power supply device 1 and mounting frame 2 on platform PL. Support member 3 includes a first support member 31 and a second support member 32. First support member 31 is fixed to mounting frame 2. Second support member 32 is detachably attached to mounting frame 2.

First support member 31 is an insulator. The insulator is made of, for example, fiber reinforced plastic (FRP). Second support member 32 is a non-insulator. The non-insulator is made of, for example, a metal. More specifically, the non-insulator is made of, for example, steel, iron, or the like. Also, second support member 32 may be an insulator. In this case, the insulator may be made of fiber reinforced plastic.

The configuration of first support member 31 and the configuration of second support member 32 will be described in detail with reference to Figs. 1 to 3.

In the present embodiment, support member 3 includes a plurality of first support members 31 and a plurality of second support members 32. Specifically, support member 3 includes four first support members 31 disposed at four corners of DC power transmission converter 10 in planar view. The number of first support members 31 is not limited to four. Specifically, support member 3 includes two second support members 32 disposed at a central region of DC power transmission converter 10 in planar view. The number of second support members 32 is not limited to two.

First support member 31 includes a first column P1. In the present embodiment, first column P1 is formed into a cylindrical shape. First column P1 is not limited to a cylindrical shape. First support member 31 includes a mounting member MM. The upper end of first column P1 is fixed to a mounting frame 2 disposed at the uppermost position. The central part of first column P1 is fixed to a plurality of mounting frames 2. The lower end of first column P1 is fixed to the mounting member MM. The mounting member MM is attached to platform PL.

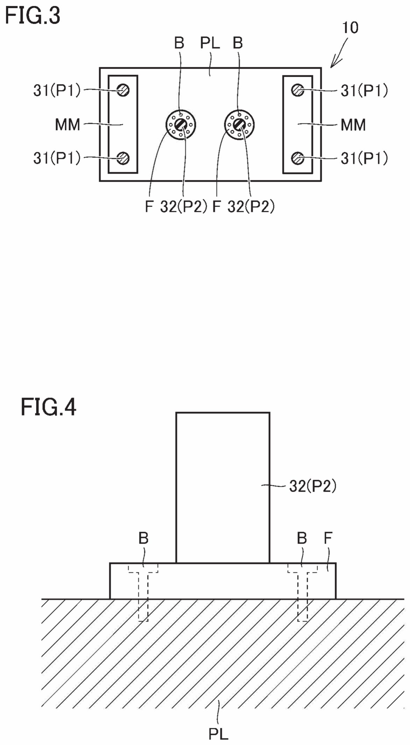

The configuration of second support member 32 of support member 3 will be described in more detail with reference to Figs. 3 and 4.

Second support member 32 includes a second column P2. In the present embodiment, second column P2 is formed into a cylindrical shape. Second column P2 is not limited to a cylindrical shape. Second support member 32 includes a flange F. The upper end of second column P2 is detachably attached to a mounting frame 2 disposed at the lowermost position. The lower end of second column P2 is attached to flange F. Flange F is disposed at an end of second support member 32 opposite to mounting frame 2. Flange F is detachably attached to platform PL by a bolt B. In the present embodiment, flange F is formed into an annular shape. Flange F is not limited to an annular shape. In the present embodiment, flange F is detachably attached to platform PL by a plurality of bolts B. The plurality of bolts B are spaced apart from each other along the circumferential direction of flange F.

Next, the effects of DC power transmission converter 10 according to the first embodiment will be described in comparison with a comparative example.

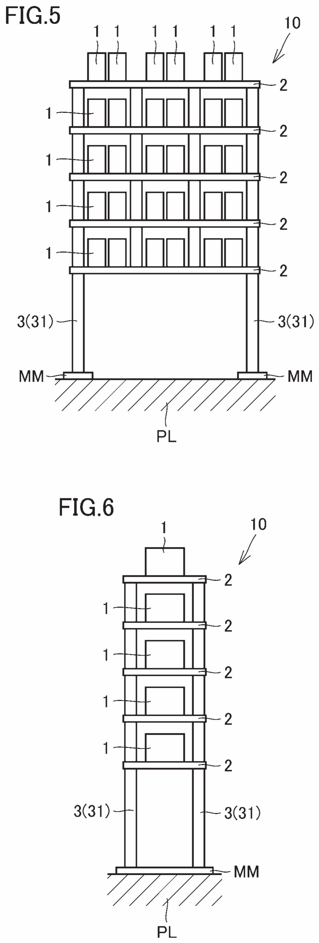

With reference to Figs. 5 and 6, in a DC power transmission converter 10 according to a first comparative example, support member 3 includes only a first support member 31. Therefore, DC power transmission converter 10 according to the first comparative example has lower earthquake resistance than DC power transmission converter 10 according to the first embodiment which further includes a second support member 32.

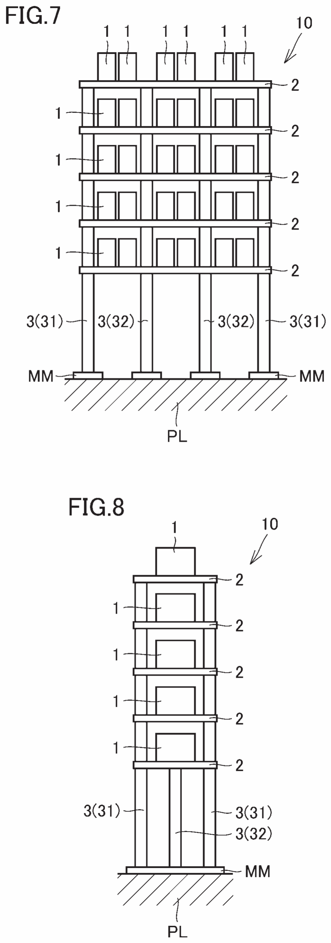

With reference to Figs. 7 and 8, in a DC power transmission converter 10 according to a second comparative example, support member 3 includes a first support member 31 and a second support member 32. However, in DC power transmission converter 10 according to the second comparative example, second support member 32 is fixed to mounting frame 2. Therefore, in DC power transmission converter 10 according to the second comparative example, second support member 32 is applied permanently not only during the transportation period but also during the operation period. Therefore, second support member 32 leads to a product design constraint and an increase in cost.

In DC power transmission converter 10 according to the first embodiment, support member 3 includes a first support member 31 and a second support member 32. Therefore, the earthquake resistance requirement can be satisfied by second support member 32 as compared with the case where support member 3 includes only first support member 31. Second support member 32 is detachably attached to mounting frame 2. Therefore, second support member 32 can be applied temporarily.

In an offshore DC converter, platform PL is installed as a floating member on ocean. In an offshore DC-DC converter, unlike a land DC-DC converter in which platform PL is installed on land, the shaking between the sea surface and platform PL is mitigated. Therefore, the earthquake resistance of an offshore DC converter is lower than that of a land DC converter during the operation period. In addition, the offshore DC converter is transported to an ocean after assembled on land. The offshore DC converter is required to have higher earthquake resistance during the transportation period than during the operation period. Therefore, the earthquake resistance during the transportation period can be enhanced by temporarily applying second support member 32 during the transportation period. On the other hand, when second support member 32 is not applied during the operation period, as compared with a case where second support member 32 is applied permanently during the operation period as well, it is possible to reduce the product design constraint and an increase in cost.

Further, in the case where the earthquake resistance of an offshore DC converter is required to be temporarily enhanced due to a typhoon or the like, the earthquake resistance of the offshore DC converter can be temporarily enhanced by temporarily applying second support member 32. On the other hand, when the enhancement for the earthquake resistance of the offshore DC converter is not required, such as after a typhoon has passed away, second support member 32 may be removed, it is possible to reduce the product design constraint and an increase in cost as compared with a case where second support member 32 is applied permanently during the operation period as well.

As described above, in DC power transmission converter 10 according to the first embodiment, by temporarily applying second support member 32, it is possible to temporarily increase the earthquake resistance in response to the earthquake resistance requirement. Therefore, as compared with a case where second support member 32 is applied permanently during the operation period as well, it is possible to reduce the product design constraint and an increase in cost.

In DC power transmission converter 10 according to the first embodiment, second support member 32 is a non-insulator. Thus, it is necessary to electrically insulate mounting frame 2 and platform PL from each other during the operation period. On the other hand, it is not necessary to electrically insulate mounting frame 2 and platform PL from each other during a period other than the operation period, for example, during the transportation period. Therefore, a non-insulator may be used as second support member 32 during a period other than the operation period. By using a non-insulator which has a higher strength than an insulator as second support member 32, it is possible to increase the strength of second support member 32. Further, by using a non-insulator which is cheaper than an insulator as second support member 32, it is possible to reduce the cost of second support member 32.

In addition, an offshore DC converter system may be stopped due to a typhoon or the like. In this case, it is not necessary to electrically insulate mounting frame 2 and platform PL from each other. Therefore, a non-insulator may be used as second support member 32. By using a non-insulator which has a higher strength than an insulator as second support member 32, it is possible to increase the strength of second support member 32. Further, by using a non-insulator which is cheaper than an insulator as second support member 32, it is possible to reduce the cost of second support member 32.

In DC power transmission converter 10 according to the first embodiment, flange F is disposed at an end of second support member 32 opposite to mounting frame 2. Therefore, second support member 32 can be easily attached to or detached from platform PL by flange F.

### Second Embodiment.

A DC power transmission converter 10 according to a second embodiment has the same configuration and effects as those of DC power transmission converter 10 according to the first embodiment unless otherwise specified.

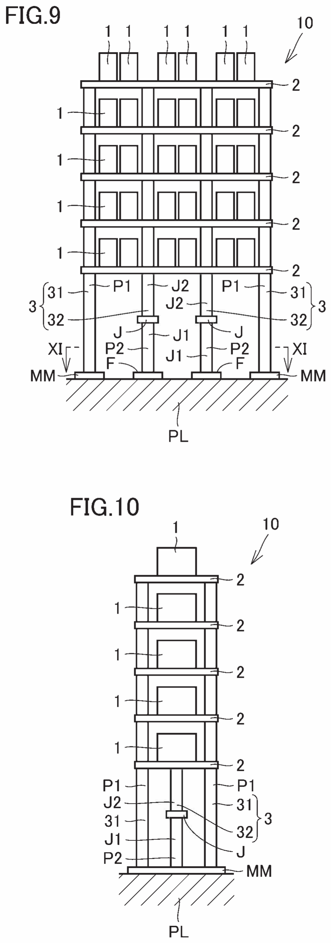

The configuration of DC power transmission converter 10 according to the second embodiment will be described with reference to Figs. 9 and 10. In DC power transmission converter 10 according to the second embodiment, second support member 32 includes a jack structure J. Jack structure J includes a main body J1 and a movable member J2. Movable member J2 is movable with respect to main body J1. Movable member J2 is movable between a state in which the movable member is in contact with mounting frame 2 and a state in which the movable member is separated from mounting frame 2. Jack structure J is, for example, a hydraulic jack.

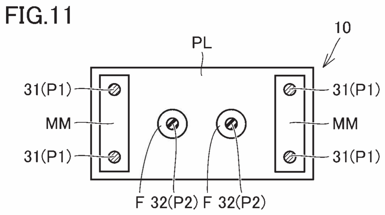

With reference to Figs. 9 and 11, second support member 32 can press mounting frame 2 and platform PL with jack structure J. Therefore, second support member 32 can support mounting frame 2 by pressing mounting frame 2 and platform PL with jack structure J. Therefore, in the present embodiment, no bolt B is attached to flange F.

Next, the effects of DC power transmission converter 10 according to the second embodiment will be described.

In DC power transmission converter 10 according to second embodiment, movable member J2 is movable between a state in which the movable member is in contact with mounting frame 2 and a state in which the movable member is separated from mounting frame 2. Therefore, second support member 32 can be easily attached to or detached from mounting frame 2.

### Third Embodiment.

A DC power transmission conversion unit 100 according to a third embodiment has the same configuration and effects as those of DC power transmission converter 10 according to the first or second embodiment unless otherwise specified.

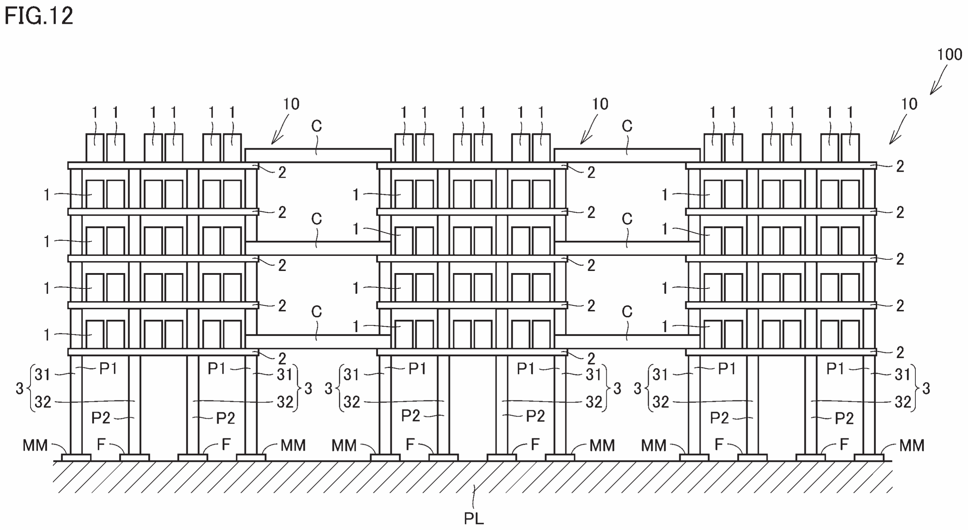

With reference to Fig. 12, DC power transmission conversion unit 100 according to the third embodiment includes a plurality of DC power transmission converters 10 according to the first embodiment. DC power transmission conversion unit 100 includes a connection member C that connects the plurality of DC power transmission converters 10 to each other. Connection member C is detachably attached to each of the plurality of DC power transmission converters 10.

Connection member C is a non-insulator. The non-insulator is made of, for example, a metal. More specifically, the non-insulator is made of, for example, steel, iron, or the like. Also, connection member C may be an insulator. In this case, the insulator may be made of fiber reinforced plastic. Connection member C may have, for example, a rod shape or a plate shape.

In the present embodiment, connection member C is detachably attached to mounting frame 2 of each of the plurality of DC power transmission converters 10. In the present embodiment, DC power transmission conversion unit 100 includes a plurality of connection members C. Each of the plurality of connection members C is detachably attached to adjacent mounting frames 2 of DC power transmission converters 10. The plurality of connection members C may not be attached to all of mounting frames 2 arranged in multiple stages. The plurality of connection members C may be attached to mounting frames 2 arranged in multiple stages every other stage. In addition, connection member C may be detachably attached to first support member 31 of each of the plurality of DC power transmission converters 10.

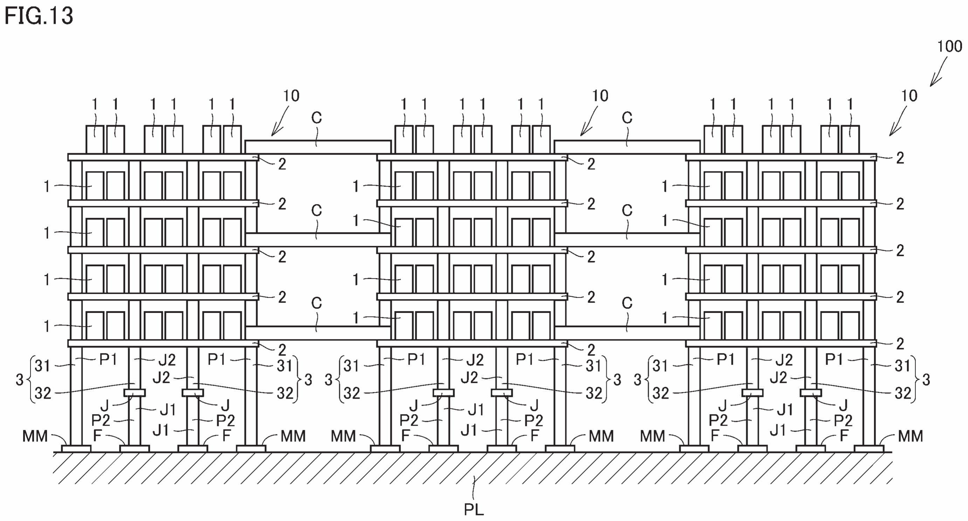

With reference to Fig. 13, a modification of DC power transmission conversion unit 100 according to the third embodiment will be described. The modification of DC power transmission conversion unit 100 according to the third embodiment includes a plurality of DC power transmission converters 10 according to the second embodiment. In other words, the modification of DC power transmission conversion unit 100 according to the third embodiment has the same configuration as DC power transmission conversion unit 100 according to the third embodiment except for second support member 32.

Next, the effects of DC power transmission converter 10 according to the third embodiment will be described.

In DC power transmission conversion unit 100 according to the third embodiment, connection member C is detachably attached to each of the plurality of DC power transmission converters 10. Therefore, by connecting the plurality of DC power transmission converters 10 to each other by connection members C, it is possible to increase the bottom surface area of DC power transmission conversion unit 100, which stabilizes the center of gravity thereof.

DC power transmission conversion unit 100 according to the third embodiment includes DC power transmission converter 10 according to the first or second embodiment. Therefore, DC power transmission converter 10 can satisfy the earthquake resistance requirement and can be applied temporarily, and further, the bottom surface area of DC power transmission conversion unit 100 can be increased to stabilize the center of gravity thereof.

It is contemplated that the embodiments disclosed herein may be appropriately combined.

It should be understood that the embodiments disclosed herein are illustrative and non-restrictive in all respects. The scope of the present invention is defined by the terms of the claims rather than the description of the embodiments above, and is intended to include any modifications within the scope and meaning equivalent to the terms of the claims.

### REFERENCE SIGNS LIST

1: power supply device; 2: mounting frame; 3: support member; 10: DC power transmission converter; 31: first support member; 32: second support member; 100: DC power transmission conversion unit; B: bolt; C: connection member; F: flange; J: jack structure; J1: main body; J2: movable member; P1: first column; P2: second column; PL: platform.

## Claims

1. A DC power transmission converter comprising:
a power supply device;
a mounting frame on which the power supply device is mounted; and
a support member that supports the mounting frame,
the support member including a first support member and a second support member,
the first support member being fixed to the mounting frame, and
the second support member being detachably attached to the mounting frame.

2. The DC power transmission converter according to claim 1, wherein
the first support member is an insulator, and
the second support member is a non-insulator.

3. The DC power transmission converter according to claim 1 or 2, wherein
the second support member includes a flange, and
the flange is disposed at an end of the second support member opposite to the mounting frame.

4. The DC power transmission converter according to any one of claims 1 to 3, wherein
the second support member includes a jack structure,
the jack structure includes a main body and a movable member movable with respect to the main body, and
the movable member is movable between a state in which the movable member is in contact with the mounting frame and a state in which the movable member is separated from the mounting frame.

5. A DC power transmission conversion unit comprising:
a plurality of DC power transmission converters, each of which is defined in any one of claims 1 to 4; and
a connection member that connects the plurality of DC power transmission converters to each other,
the connection member being detachably attached to each of the plurality of DC power transmission converters.
